Europäisches Patentamt

**European Patent Office**

**Office européen des brevets**

(19)

(11) Veröffentlichungsnummer: **0 043 351**
**A2**

(12) **EUROPÄISCHE PATENTANMELDUNG**

(21) Anmeldenummer: **81810263.4**

(22) Anmeldetag: **26.06.81**

(51) Int. Cl.³: **B 23 K 15/00**
**H 01 J 3/30**

(30) Priorität: **01.07.80 DD 222294**

(43) Veröffentlichungstag der Anmeldung:
**06.01.82 Patentblatt 82/1**

(84) Benannte Vertragsstaaten:
**DE FR GB**

(71) Anmelder: **Jenoptik Jena G.m.b.H.**
**Carl-Zeiss-Strasse 1**
**DDR-6900 Jena(DD)**

(84) Benannte Vertragsstaaten:
**DE**

(71) Anmelder: **VEB Carl Zeiss Jena**
**Carl-Zeiss-Strasse 1**
**DDR-6900 Jena(DD)**

(84) Benannte Vertragsstaaten:
**FR GB**

(72) Erfinder: **Kuschel, Georg, Dr.**
**W.-Piek-Strasse 16**
**DDR-6902 Jena-Lobeda(DD)**

(72) Erfinder: **Reinhardt, Hartmut**
**Nr. 59b**
**DDR-5301 Grosschwabhausen(DD)**

(74) Vertreter: **Bovard, Fritz Albert et al,**
**Bovard & Cie Patentanwälte VSP Optingenstrasse 16**
**CH-3000 Bern 25(CH)**

(54) **Elektrostatisches Ablenksystem.**

(57) Ein elektrostatisches Ablenksystem für Korpuskular-strahlen, bei dem einander gegenüberliegende Elektroden (5,6) mit einstellbaren Potentialen zur Ablenkung benutzt werden. Zur Erhöhung der Produktivität von Korpuskular-strahlgeräten besteht die Aufgabe, einen sich bewegenden Korpuskularstrahl über seinen gesamten Schwenkbereich oder viele nebeneinanderliegende statische Korpuskular-strahlen gleichzeitig zu steuern. Das wird dadurch erreicht, daß eine Vielzahl von Elektroden (5,6) auf mindestens einem Paar einander gegenüberliegender, im wesentlichen gleich-gerichteter Flächen (3,4) jeweils in einer Reihe nebeneinan-der liegend angeordnet sind. Jede Elektrode wenigstens einer der beiden Flächen eines Paares weist eine eigene Potentialzuführung (15, 16) auf. Die dem Korpuskularstrahl zugewandten Flächenteile zwischen den Elektroden sind elektrisch leitend.

Fig.1

## Elektrostatisches Ablenksystem

Die Erfindung betrifft ein elektrostatisches Ablenksystem für Korpuskularstrahlen, bei dem einander gegenüberliegende Elektroden mit einstellbaren Potentialen zur Ablenkung mindestens eines Korpuskularstrahles vorgesehen sind. Derartige Ablenksysteme sind insbesondere in Elektronen- und Ionenstrahlbearbeitungsanlagen verwendbar.

Die bekannten elektrostatischen Ablenksysteme weisen ein bzw. zwei Paare von Ablenkelektroden auf, die einen Korpuskularstrahl mit festem oder variablem Querschnitt in einer bzw. zwei Richtungen ablenken. Für die Herstellung komplizierter Strukturen müssen dem Korpuskularstrahl alle notwendigen Ablenkvektoren zeitlich nacheinander aufgeprägt werden. Infolge der begrenzten Übertragungsgeschwindigkeit von einem Informationsspeicher bis zu einem strahlenempfindlichen Objekt wird die Produktivität aller Bearbeitungsanlagen sehr beschränkt.
Eine weitere Beschränkung ergibt sich daraus, daß mit einem einzelnen Korpuskularstrahl nur ein begrenzter Strahlstrom übertragen werden kann.

Durch die Erfindung sollen die dargelegten Mängel behoben und ein elektrostatisches Ablenksystem angegeben werden, das die Produktivität von Korpuskularstrahlgeräten erheblich zu steigern gestattet.

Aufgabe der Erfindung ist es, ein elektrostatisches Ablenksystem zu schaffen, das die parallele Steuerung eines sich bewegenden Korpuskularstrahles oder vieler statischer Korpuskularstrahlen unabhängig voneinander durch eine geeignete Anordnung und Ausbildung von Elektroden ermöglicht.

Gemäß der Erfindung wird diese Aufgabe dadurch gelöst, daß eine Vielzahl von Elektroden auf mindestens einem Paar einander gegenüberliegender, im wesentlichen gleichgerichteter Flächen jeweils in einer Reihe nebeneinander liegend angeordnet sind, daß jede Elektrode wenigstens einer der beiden Flächen eines Paares eine eigene Potentialzuführung aufweist und daß die dem Korpuskularstrahl zugewandten Flächenteile zwischen den Elektroden elektrisch leitend sind. Die Erfindung ermöglicht eine schnelle und vielgestaltige Auslenkung von Korpuskularstrahlen, die entlang einer Linie angeordnet sind. In Elektronenstrahlgeräten gestattet sie zusammen mit einer Austastblende und weiteren elektronenoptischen Mitteln jeden Elektronenstrahl für sich hell oder dunkel zu steuern.

Eine konstruktiv einfache Lösung ergibt sich, wenn die Elektroden einer der beiden Flächen elektrisch leitend miteinander verbunden sind. Im günstigsten Fall sind diese Elektroden zu einer einzigen leitfähigen Fläche vereinigt. Für die Herstellung der Elektrodenreihen und ihre Verwendung in Korpuskularstrahlgeräten ist es vorteilhaft, wenn sich die Elektroden auf ebenen rechteckigen Trägerflächen befinden, die einen spitzen Winkel miteinander einschließen, dessen Scheitellinie im wesentlichen parallel zu den Elektrodenreihen verläuft.

Es ist empfehlenswert, die Form und Anordnung der den Korpuskularstrahl steuernden Elektroden von der jeweiligen Richtung des Korpuskularstrahls abhängig zu machen. Die Elektroden haben viereckige, rechteckige oder parallelogrammartige Form, wobei zwei Kanten zum Korpuskularstrahl im wesentlichen parallel und zwei Kanten zum Korpuskularstrahl im wesentlichen senkrecht gerichtet sind. Die Elektroden einer Reihe liegen vorzugsweise äquidistant zueinander.

Die Elektroden können entweder selbsttragend sein, sie benötigen keinen Träger; die einander gegenüberliegenden Flächen sind dann vorzugsweise fiktiv und durch die Elektrodenebenen einer Reihe bestimmt. Oder die Elektroden befinden sich an zwei Grundkörpern, die an ihren dem eintretenden Korpuskularstrahl zugewandten Flächen mit leitenden Oberflächen versehen sind, die mit dem in der Nähe der einandergegenüberliegenden Flächen befindlichen Teilen diese Flächen gegen eine unmittelbare Bestrahlung mit Korpuskeln schützen. Die leitenden Oberflächen insgesamt verhindern Aufladungserscheinungen und damit unkontrollierbare Ablenkungen der Korpuskularstrahlen. Die Grundkörper bestehen aus einem genügend hochohmigen Material, vorzugsweise Reinstsilizium und weisen unter jeder Elektrode mit eigener Potentialzuführung eine isolierende Schicht auf. Jeder Grundkörper kann auch aus einem isolierenden Material bestehen. In diesem Fall werden die Flächenteile zwischen den Elektroden mit einer Schicht geeigneter elektrischer Leitfähigkeit belegt, damit auch in diesem Fall unerwünschte Aufladungen vermieden werden.

Für eine einfache Herstellung ist vorteilhaft jeder Grundkörper durch ebene Flächen begrenzt. Dabei befinden sich die voneinander isolierten Potentialzuführungen zweckmäßigerweise auf der dem eintretenden Korpuskularstrahl abgewandten Fläche des Grundkörpers, die im Sinne einer günstigen Herstellungstechnologie für die Elektrodenreihen mit der zugehörigen Trägerfläche einen stumpfen Winkel einschließt.

- 4 -

Elektronenoptisch ist von Vorteil, wenn die einander gegenüberliegenden Flächen einen Spalt bilden und mit den auf ihr befindlichen Elektroden zur Mittelebene des Spaltes spiegelsymmetrisch angeordnet sind. Dadurch wird die Trennung der unabhängig voneinander zusteuernden Korpuskularstrahlung verbessert.

Vorteilhafterweise werden die Potentialzuführungen an der dem eintretenden Korpuskularstrahl abgewandten Fläche jedes Grundkörpers durch eine elektrisch leitfähige Platte abgedeckt. Dadurch wird eine Beeinflussung des Korpuskularstrahls durch die Zuleitungen und eine Bestrahlung dieser Zuleitungen und deren Zwischenräume durch Streuelektronen oder -ionen verhindert. Die Potentialzuführungen sind über elektronische Schalter und speichernde Register mit einem Rechner verbunden, von dem die Zuführung der Potentiale zu den einzelnen Elektroden einer Reihe nach einem vorgegebenen Programm gesteuert werden. Ist dabei der elektronische Schalter ein einfacher Schalter, so wird wahlweise ein Normpotential oder ein festes, von einem Normpotential abgeleitetes Potential an die Zuleitung angelegt. Ist der elektronische Schalter ein DA-Wandler mit n bit, so wird wahlweise eines von $2^n$ verschiedenen, vom Normpotential abgeleiteten Potentialen an die Zuleitung angelegt und damit eine stufenweise Auslenkung der einzelnen Strahlen gewährleistet.

Durch die Erfindung wird ein Vielfachablenksystem geschaffen, bei dem entsprechend der Anzahl der in einer Reihe angeordneten Elektroden für eine große Anzahl, z.B. für 518 Korpuskularstrahlen die Ablenkungsinformationen gleichzeitig anliegen und diese Ablenkungen auch gleichzeitig erfolgen können.

Die Erfindung wird nachfolgend anhand der schematischen Zeichnung näher erläutert.

Es zeigen

3627

Fig. 1   einen Querschnitt durch ein erfindungsgemäßes
         Ablenksystem,

Fig. 2   eine der einander gegenüberliegenden Flächen
         des Ablenksystems,

Fig. 3   die Potentialzuführungen zu den Elektroden,

Fig. 4   ein erfindungsgemäßes Ablenksystem mit zwei
         Spalten,

Fig. 5   ein mit einer Blende versehenes Ablenksystem,

Fig. 6   die Verwendung eines erfindungsgemäßen Ablenksystems in einem Elektronenstrahlgerät.

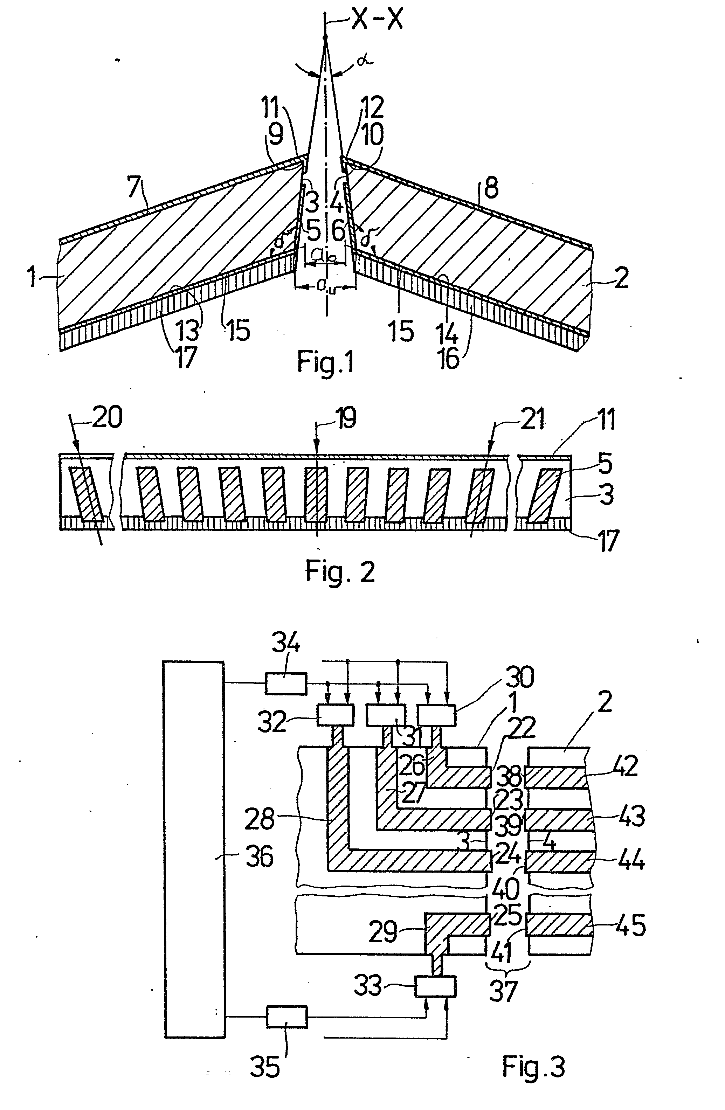

In Fig. 1 sind zwei aus Quarz bestehende Grundkörper 1;2 zueinander und zu einer Symmetrieebene X-X geneigt; ihre einander gegenüberliegenden Flächen 3;4 sind die Trägerflächen einer Vielzahl ($>$100) von Elektroden 5;6 und schließen miteinander einen Winkel $\alpha$ ein.
Entsprechend dem von ihnen eingeschlossenen Keilwinkel haben sie einen oberen Abstand $a_o$ und einen unteren Ab-stand $a_u$, wobei $a_u > a_o$ ist. Auf der oberen Fläche 7 bzw. 8 des Grundgerätes 1 bzw. 2 und entlang der Kante 9 bzw. 10 jedes Grundkörpers befindet sich eine Kantenelektrode 11 bzw. 12. An den unteren Flächen 13; 14 der Grundkörper 1;2 sind Zuleitungen 15; 16 für die Potentiale der Elektroden 5;6 angeordnet. Die Potentialzuführungen werden durch eine elektrisch leitende Platte 17 bzw. 18 abgedeckt. Die unteren Flächen 13; 14 bilden mit den entsprechenden Trägerflächen 3;4 stumpfe Winkel .

In Fig. 2 ist die Trägerfläche 3 mit den Elektroden 5 in Ansicht dargestellt. Dabei ist die Anzahl der Elektroden 5 aus Darstellungsgründen stark reduziert worden. Mit 11 ist wieder die Kantenelektrode und mit 17 die Abschirmplatte bezeichnet. Exemplarisch sind drei Korpuskularstrahlen 19; 20; 21 eingezeichnet; dabei ist zu erkennen, daß die Neigungen der Elektroden 5 diese vom Rechteck zum Parallelogramm werden lassen, dessen Längsseiten jeweils parallel zum eintretenden Korpuskularstrahl ver-

- 6 -

laufen. Die Kantenelektrode 11 ist vorzugsweise aus Schwermetall hergestellt und dient der Abschirmung des Inneren des spaltförmigen Zwischenraumes zwischen den Flächen 3; 4 (Fig. 1) gegen die unmittelbare Bestrahlung. Die Elektroden 5 bestehen aus einem Material hoher Leitfähigkeit, vorzugsweise aus einem dünnen Metallbelag. Die zwischen den Elektroden befindlichen Flächen weisen eine geringe elektrische Leitfähigkeit auf, so daß auftretende Streuelektronen keine wesentliche Potentialverfälschungen liefern, die Potentialunterschiede zwischen den Elektroden 5 jedoch zu keinen belastenden Strömen führen.

In Fig. 3 sind die beiden Grundkörper 1 und 2 von unten dargestellt. Ein Teil des Grundkörpers 1 besitzt Elektroden 22; 23; 24; 25 und zugehörige Potentialzuführungen 26; 27; 28; 29, über die die Elektroden 22; 23; 24; 25 mit elektronischen Schaltern 30; 31; 32; 33 verbunden sind. Die elektronischen Schalter stehen über speichernde Register 34; 35 mit einem Rechner 36 in Verbindung. Auf dem Grundkörper 2, der mit dem Grundkörper 1 einen keilförmigen Spalt 37 bildet, hat die der Fläche 3 gegenüberliegende Fläche 4 Elektroden 38; 39; 40; 41, die zu denen der Fläche 3 spiegelsymmetrisch liegen und die an Potentialzuführungen 42;43;44;45 angeschlossen sind. Des weiteren sind nicht dargestellte elektronische Schalter und speichernde Register vorgesehen, die ebenso wie die elektronischen Schalter 30 bis 33 und die Register 34;35 mit dem Rechner verbunden sind. Jeder Schalter 30 bis 33 legt ein festes Potential oder das Potential Null an die zu ihm gehörende Potentialzuführung 26 bis 29 und damit an die ihm zugehörige Elektrode 22 bis 25. Die gegenüberliegenden Elektroden 38 bis 41 erhalten über ihre Zuleistungen 42 bis 45 ~~gleich~~ entgegengesetzt gerichtete Potentiale oder alle das Potential Null. Entsprechend den an die Elektroden angelegten Potentialen wird ein jeweils zwischen zwei Elektroden, beispielsweise 22 und 38, befindlicher nicht dargestellter Korpuskularstrahl rechtwinklig zum Spalt 37 ausgelenkt. Dasselbe gilt für die zwischen den anderen einander gegenüberliegenden Elektroden befindlichen Strahlen. Die Schaltzustände der elektronischen Schalter 30 bis 33 werden von den elektronischen Registern 34; 35 gesteuert und festgehalten. Der Rechner 36 versieht die Register mit den erforderlichen Speicherinhalten und setzt so die Potentiale der Elektroden 22 bis 25 auf ihre Sollwerte. In gleicher Weise wirkt der Rechner 36 auf die Elektroden 38 bis 41 ein.

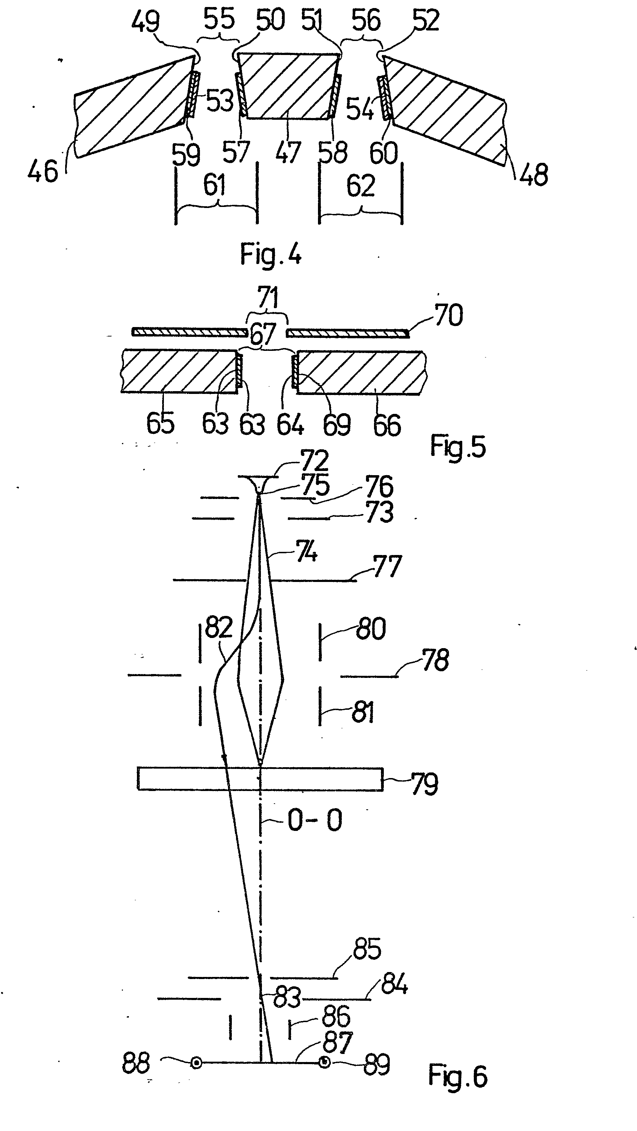

Fig. 4 zeigt ein Ablenksystem mit zwei keilförmigen Spalten 55; 56; das drei aus Reinstsilizium bestehenden Grundkörpern 46; 47; 48 aufweist, die an ihren einander gegenüberliegenden Flächen 49; 50; 51; 52 mit Elektroden versehen sind. Dabei sind auf den Flächen 49 und 52 Elektrodenreihen 53; 54, wie zu Fig. 2 beschrieben, angeordnet, während auf die Flächen 50 und 51 des Grundgerätes 47 flächenförmige, auf Nullpotential befindliche Elektroden 57 und 58 aufgebracht sind. Im Gegensatz zu Fig. 2 sind die Elektroden 53; 54 auf gleichgroßen isolierenden Schichten 59;60 aus Siliziumdioxid angeordnet, die sich zwischen den Flächen 50; 51 einerseits und Elektroden 53; 54 andererseits befinden. Die Verwendung zweier Spalte ermöglicht die Anlegung der Potentiale an die Elektronenreihe 54 des zweiten Spaltes 56 während der erste Spalt 55 der Ablenkung des Korpuskularstrahlen und der Belichtung eines Objektes dient. Unter den Spalten 55; 56 sind zwei Ablenksysteme vorgesehen, die ein Zusammenfallen der durch die Spalte 55; 56 gebildeten Linie in einer nicht dargestellten Bildebene bewirken. Damit können sie der Schaffung von Graustufen oder Korrekturbildung dienen.

Fig. 5 zeigt eine weitere Anordnung zweier Elektrodenreihen 63; 64 tragender Grundkörper 65; 66. Die die Elektroden 63; 64 tragenden, einen Spalt 67 begrenzenden Flächen 68; 69 der Grundkörper sind zueinander parallel. In dem Fall ist vor den Grundkörpern 65;66 eine Blende 70 angeordnet, deren Öffnung 71 kleiner ist als der Abstand der Flächen 68; 69 voneinander, um den Abbildungsprozeß störende Korpuskeln von den Grundkörpern 65; 66 abzuschirmen. Im Übrigen ist die Anordnung so getroffen, wie sie zu den Fig. 1 bis 3 beschrieben worden ist.

In Fig. 6 sendet eine Kathode 72 unter der Wirkung einer Anode 73 ein Elektronenstrahlbündel 74 aus, dessen engste Stelle sich an einem Crossover 75 befindet und dessen Intensität von einer Wehneltelektrode 76 bestimmt wird. Eine Strahlblende 77 begrenzt das Elektronenstrahlbündel 74 auf einen definierten Querschnitt. Eine Linse 78 fokussiert das Elektronenstrahlbündel auf ein erfindungsgemäßes Vielfachablenksystem 79. Zu beiden Seiten der Linse 78 sind zwei Ablenksystem 80; 81 angeordnet, von denen das Ablenksystem 80 einen in der Achse O-O des Elektronenstrahlgerätes verlaufenden Elektronenstrahl 82 auslenkt und das Ablenksystem 81 diesen Elektronenstrahl mit Mittelpunkt 83 einer zweiten Linse 84 lenkt. Vor der Linse 84 ist eine Austastblende 85 angeordnet, ein weiteres Ablenksystem 86 ist ihr nachgeordnet, das zur Feinpositionierung des Elektronenstrahls 82 in der Bildebene dient, die mit der Oberfläche eines Tisches 87 zusammenfällt, der entlang von rechtwinklig zur Zeichenebene gerichteten Führungen 88; 89 verschiebbar ist. Indem die Linse 78 den Crossover 75 auf das Vielfachablenkungssystem 79 abbildet, wird dessen Spalt gleichmäßig beleuchtet. Gleichzeitig wird die gleichmäßig ausgeleuchtete Strahlblende 77 in die Austastblende 85 abgebildet, so daß der Durchmesser dieser Abbildung etwa gleich dem halben Durchmesser der Austastblende 85 ist. Die Auslenkung des Strahles 82 durch das Vielfachablenksystem 79 führt zu einer Bewegung des Bildes der Strahlblende 77 gegenüber der Austastblende 85 rechtwinklig zur Zeichenebene. Dadurch wird eine teilweise oder vollständige Hell- oder

3627

Dunkeltastung erreicht. Die dem Vielfachablenksystem 79 ähnlich wie zu Fig. 3 beschrieben angehörenden nicht dargestellten elektronischen Schalter steuern je nach der Anzahl ihrer Schaltzustände den Elektronenstrahl 82 nur hell-dunkel oder sie ermöglichen neben dem Zustand "dunkel" beispielsweise noch drei Helligkeitsstufen. Die diesen Helligkeitsstufen zugeordneten Ablenkspannungen haben jedoch eine ungleichmäßige Stufung. Durch die Linse 84 wird die obere Ebene des Vielfachablenksystems 79 in der Bildebene 87 abgebildet. Dort erscheint eine aus einzelnen Punkten bestehende, nicht dargestellte gerade Linie, deren Helligkeit bezüglich jedes Punktes eingestellt ist. In dieser Ebene kann eine Objektoberfläche bearbeitet werden. Es ist aber auch möglich, die Bildebene durch eine weitere Linse zu übertragen. Daraus ergeben sich vielfältige Möglichkeiten, das Objekt günstig zu lagern, notwendige Justierprozesse durchzuführen und die Verkleinerung der Abbildung passend zu wählen.

Patentansprüche

1. Elektrostatisches Ablenksystem für Korpuskularstrahlen, bei dem einander gegenüberliegende Elektroden mit einstellbaren Potentialen zur Ablenkung mindestens eines Korpuskularstrahles vorgesehen sind, gekennzeichnet dadurch, daß eine Vielzahl von Elektroden auf mindestens einem Paar einander gegenüberliegender, im wesentlichen gleichgerichteter Flächen jeweils in einer Reihe nebeneinander liegend angeordnet sind, daß jede Elektrode wenigstens einer der beiden Flächen eines Paares eine eigene Potentialzuführung aufweist und daß die dem Korpuskularstrahl zugewandten Flächenteile zwischen den Elektroden elektrisch leitend sind.

2. Elektrostatisches Ablenksystem nach Anspruch 1, gekennzeichnet dadurch, daß die Elektroden einer der beiden Flächen elektrisch leitend miteinander verbunden sind.

3. Elektrostatisches Ablenksystem nach Anspruch 2, gekennzeichnet dadurch, daß die elektrisch leitend miteinander verbundenen Elektroden eine einzige elektrisch leitende Fläche bilden.

4. Elektrostatisches Ablenksystem nach Anspruch 1, gekennzeichnet dadurch, daß sich die Elektroden auf ebenen rechteckigen Trägerflächen befinden, die einen spitzen Winkel miteinander einschließen, dessen Scheitellinie im wesentlichen parallel zu den Elektrodenreihen verläuft.

5. Elektrostatisches Ablenksystem nach Anspruch 1, gekennzeichnet dadurch, daß die Elektroden viereckige Flächen sind, von denen jede zwei zum Korpuskularstrahl im wesentlichen parallel und zwei zum Korpuskularstrahl im wesentlichen rechtwinklig gerichtete Kanten aufweist.

6. Elektrostatisches Ablenksystem nach Anspruch 5, gekennzeichnet dadurch, daß die Elektroden äquidistante Abstände voneinander haben.

7. Elektrostatisches Ablenksystem nach Anspruch 4, gekennzeichnet dadurch, daß jede der einander gegenüberliegenden Flächen einem Grundkörper angehört, der auf seiner dem eintretenden Korpuskularstrahl zugewandten Fläche mit einer leitenden Oberfläche versehen ist.

8. Elektrostatisches Ablenksystem nach Anspruch 7, gekennzeichnet dadurch, daß die Grundkörper aus Reinstsilizium bestehen und daß sich zwischem dem Grundkörper und jeder Elektrode mit eigener Potentialzuführung eine isolierende Schicht befindet.

9. Elektrostatisches Ablenksystem nach Anspruch 7, gekennzeichnet dadurch, daß die Grundkörper aus einem isolierenden Material bestehen.

10. Elektrostatisches Ablenksystem nach Anspruch 7, gekennzeichnet dadurch, daß jeder Grundkörper durch ebene Flächen begrenzt wird, daß die Potentialzuführungen sich auf der dem eintretenden Korpuskularstrahl abgewandten Fläche des Grundkörpers befinden und daß die abgewandte Fläche mit der zugehörigen Trägerfläche einen stumpfen Winkel bildet.

11. Elektrostatisches Ablenksystem nach Anspruch 1, gekennzeichnet dadurch, daß die einander gegenüberliegenden Flächen einen Spalt bilden und mit den auf ihnen befindlichen Elektroden zur Mittelebene des Spaltes spiegelsymmetrisch angeordnet sind.

12. Elektrostatisches Ablenksystem nach Anspruch 10, gekennzeichnet dadurch, daß die Potentialzuführungen durch eine elektrisch leitende Platte abgeschirmt sind.

13. Elektrostatisches Ablenksystem nach Anspruch 12, gekennzeichnet dadurch, daß die Potentialzuführungen über elektronische Schalter und speichernde Register mit einem Rechner verbunden sind.

Fig.1

Fig. 2

Fig.3

Fig. 4

Fig. 5

Fig. 6